# EUROPÄISCHE PATENTANMELDUNG

(11) **EP 1 020 787 A2**
(43) Veröffentlichungstag der Anmeldung: **19.07.2000**
(21) Anmeldenummer: 00100101.5
(22) Anmeldetag: 04.01.2000
(51) Int. Cl.: G06F 1/26

(54) **Schaltungsanordnung mit Signalspannungsanpassung**

(30) Priorität: 14.01.1999 DE 29900527 U
(71) Anmelder: SIEMENS AKTIENGESELLSCHAFT, 80333 München (DE)
(72) Erfinder: Fichtner, Norbert, Dipl.-Ing. (FH), 84069 Schierling (DE); Munz, Dieter, Dipl.-Ing. (FH), 91315 Höchstadt (DE)

(57) **Zusammenfassung**

Schaltungsanordnung (1), insbesondere als integrierte Schaltung, die mit Anwenderelektronik (2) unterschiedlicher Kommunikationsspannungen über eine Schnittstelle (7) der Schaltungsanordnung (1) verbunden ist. Es ist vorgesehen, daß die Schaltungsanordnung (1) eine Umschalteinrichtung (8) zwischen verschiedenen Kommunikationsspannungen aufweist, die an der Schnittstelle (7) der Schaltungsanordnung (1) einen zusätzlichen Eingang (9) für die Kommunikationsspannung aufweist, wobei der zusätzliche Eingang (9) mit einem Abgriff (10) für die Kommunikationsspannung der Anwenderelektronik (2) verbindbar ist.

## Beschreibung

Die Erfindung bezieht sich auf eine Schaltungsanordnung, insbesondere als integrierte Schaltung, die mit Anwenderelektronik unterschiedlicher Kommunikationsspannung über eine Schnittstelle der Schaltungsanordnung verbunden ist. Unter Kommunikationsspannung wird hier allgemein die Signalspannung zwischen einer Anwenderelektronik und der Schaltungsanordnung verstanden.

Eine Anwenderelektronik arbeitet mit einem bestimmten Spannungspegel, so weisen digitale Logikschaltungen häufig 5 V-Familien oder 3,3 V-Familien auf. Eine Schaltungsanordnung, die mit derartigen Anwenderschaltungen zusammenarbeiten soll, muß beim Auswechseln einer Anwenderschaltung durch eine mit anderem Spannungs- bzw. Signalpegel die Kommunikationsspannung umgesetzt erhalten.

Der Erfindung liegt die Aufgabe zugrunde, eine Schaltungsanordnung zu entwickeln, die sich automatisch an eine andere Signalspannung anpaßt.

Die Lösung der geschilderten Aufgabe erfolgt nach der Erfindung durch eine Schaltungsanordnung nach Anspruch 1. Die Schaltungsanordnung weist eine Umschalteinrichtung zwischen verschiedenen Kommunikationsspannungen auf, die an der Schnittstelle der Schaltungsanordnung einen zusätzlichen Eingang für die Kommunikationsspannung aufweist, wobei der zusätzliche Eingang mit einem Abgriff für die Kommunikationsspannung der Anwenderelektronik verbindbar ist. Die Umschalteinrichtung wird dann entsprechend der Kommunikationsspannung der Anwenderelektronik geführt und auf den entsprechenden Spannungspegel für die Kommunikation zwischen Anwenderelektronik eingestellt. Die Anpassung an die Signalspannung erfolgt dadurch ohne zusätzliche Bauelemente, wie Pegelwandler, selbsttätig, also automatisch.

Die Umschalteinrichtung kann insbesondere eine Einheit für die Umschaltung der Eingangsschwellen und eine Einheit für die Umschaltung von Signalpegeln aufweisen. Dadurch werden die Eingangsschwellen und die Signalpegel auf die für die Schaltungsanordnung geeigneten Werte in Abstimmung eingestellt.

Die Schnittstelle der Schaltungsanordnung kann vorzugsweise als sogenanntes digitales Interface ausgebildet sein. Weiter kann die Schnittstelle als serielle Schnittstelle für asynchrone Übertragung ausgeführt sein. Derartige Schnittstellen werden auch als UARP bezeichnet. Bei Einsatz auf dem Gebiet der Gebäudesystemtechnik mit einem Bus in verdrillter Zweidrahttechnik (englisch: twisted pair) spricht man auch von einer TPUARP-Schnittstelle.

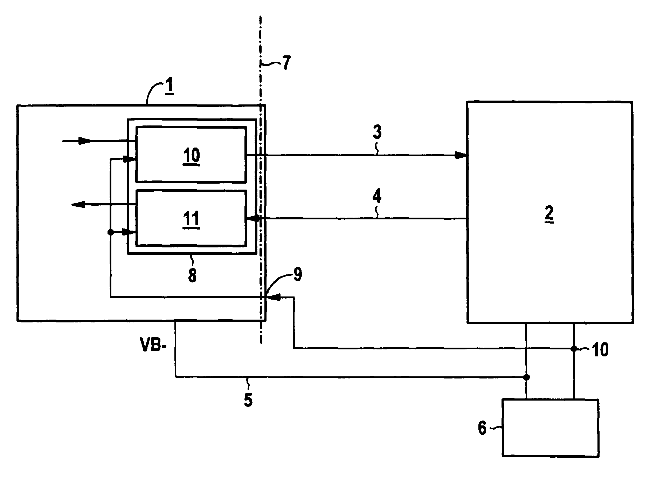

Die Erfindung soll nun anhand eines in der Zeichnung grob schematisch wiedergegebenen Ausführungsbeispiels näher erläutert werden:

Die Schaltungsanordnung 1 arbeitet mit einer Anwenderelektronik 2, die als digitale Logikschaltung ausgeführt sein kann. Zwischen der Schaltungsanordnung 1 und der Anwenderelektronik 2 bestehen Kommunikationswege 3 und 4, die eine Kommunikationsspannung zur Anwenderelektronik 2 oder zur Schaltungsanordnung 1 zuleiten. Wenn die Schaltungsanordnung 1 als Busankoppler der Gebäudesystemtechnik für einen Bus der European Installation Bus Association, EIBA, ausgeführt ist, ist Bezugspotential 5 die negativen Busspannung VB-. Die Anwenderelektronik 2 wird durch ein Netzteil 6 versorgt. Die Bordnetzversorgung der Schaltungsanordnung 1 ist in der Zeichnung der Einfachheit halber weggelassen. Hierfür kann der Leiter mit dem positiven Potential verwendet werden. Über die zwei Leiter eines derartigen Busses wird auch die Information übertragen.

Die Schaltungsanordnung 1 weist eine Schnittstelle 7 auf, die eine Umschalteinrichtung 8 hat. Die Umschalteinrichtung ist bei einer als Autor ausgeführten Anwenderelektronik zumindest dafür ausgelegt, die Signalpegel und bei einem Sensor die Eingangsshwellen der Kommunikationsspannung in der Schaltungsanordnung 1 zwischen vorgesehenen Werten umzuschalten. An einem zusätzlichen Eingang 9 erhält die Schnittstelle 7 die Kommunikationsspannung, indem sie mit einem Abgriff 10 für die Kommunikationsspannung der Anwenderelektronik 2 verbindbar ist. Die Umschalteinrichtung 8 weist vorzugsweise, wie im Ausführungsbeispiel veranschaulicht, ein Umschaltelement 10 für den Signalpegel der Kommunikationsspannung und ein Umschaltelement 11 für die Umschaltung der Eingangsschwellen auf. Die Schnittstelle 7 der Schaltungsanordnung 1 kann vorzugsweise als digitales Interface ausgebildet sein. Insbesondere kann sie als serielle Schnittstelle für asynchrone Übertragung ausgeführt sein, wofür sich die Bezeichnung UARP eingeführt hat. Bei Einsatz für ein Bussystem mit verdrillter Zweidrahtleitung spricht man auch von einer TPUARP.

Eine Spannung am zusätzlichen Eingang 9 führt dazu, daß der Signalpegel der Schaltungsanordnung an die angeschlossene Anwenderelektronik angepaßt wird. Im Ausführungsbeispiel werden die Eingangsschwellen der Schnittstelle und die Signalpegel der von der Schaltungsanordnung 1 zu der Anwenderelektronik 2 über den Leitungsweg 3 gesandten Signale angepaßt. Verständlicherweise können die Leitungswege 3 und 4 auch in einer einzigen Leitung zusammengefaßt sein bzw. über eine Leitung verlaufen.

## Patentansprüche

1. Schaltungsanordnung (1), insbesondere als integrierte Schaltung, die mit Anwenderelektronik (2) unterschiedlicher Kommunikationsspannungen über eine Schnittstelle (7) der Schaltungsanordnung (1) verbunden ist, **dadurch gekennzeichnet**, daß die Schaltungsanordnung (1) eine Umschalteinrichtung (8) zwischen verschiedenen Kommunikationsspannungen aufweist, die an der Schnittstelle (7) der Schaltungsanordnung (1) einen zusätzlichen Eingang (9) für die Kommunikationsspannung aufweist, wobei der zusätzliche Eingang (9) mit einem Abgriff (10) für die Kommunikationsspannung der Anwenderelektronik (2) verbindbar ist.

2. Schaltungsanordnung nach Anspruch 1, **dadurch gekennzeichnet**, daß die Umschalteinrichtung (8) eine Einheit (11) für die Umschaltung der Eingangsschwellen und eine Einheit (10) für die Umschaltung von Signalpegeln aufweist.

3. Schaltungsanordnung nach Anspruch 1 oder 2, **dadurch gekennzeichnet**, daß die Schnittstelle (7) der Schaltungsanordnung (1) als digitales Interface ausgebildet ist.

4. Schaltungsanordnung nach Anspruch 3, **dadurch gekennzeichnet**, daß die Schnittstelle (7) als serielle Schnittstelle für asynchrone Übertragung ausgeführt ist.
